# FASCICULE DE BREVET EUROPEEN

(11) **EP 0 732 809 B1**
(45) Date de publication et mention de la délivrance du brevet: **16.08.2001**
(21) Numéro de dépôt: 96400517.7
(22) Date de dépôt: 13.03.1996
(51) Int. Cl.: H03H 17/02, H03H 17/06

(54) **Dispositif de filtrage digital**
Digitale Filteranordnung
Digital filter device

(30) Priorité: 14.03.1995 FR 9502946
(43) Date de publication de la demande: 18.09.1996
(73) Titulaire: THOMSON multimedia, 92648 Boulogne Cédex (FR)
(72) Inventeur: Comminges, Martial, 92050 Paris la Defense Cédex (FR); Dell'Ova, Francis, 92050 Paris la Defense Cédex (FR); Paillardet, Frédéric, 92050 Paris la Defense Cédex (FR)
(74) Mandataire: Ruellan-Lemonnier, Brigitte

(56) Documents cités:
- US-A- 4 766 561
- EDN ELECTRICAL DESIGN NEWS, vol. 28, no. 7, Mars 1983, NEWTON, MASSACHUSETTS US, pages 193-193-197, XP002004455 J. OXAAL: "DSP HARDWARE IMPROVES MULTIBAND FILTERS"

## Description

L'invention concerne un dispositif de filtrage dans un système de traitement numérique du signal. L'invention peut notamment être utilisée pour la mise en oeuvre de plusieurs filtres digitaux en série.

L'implémentation de filtres digitaux implique souvent l'utilisation de nombreux éléments de circuit identiques, ce qui a pour conséquence un coût élevé en surface de substrat.

Il est connu du document US-A-4 766 561 un dispositif de filtrage digital d'échantillons comprenant:
un moyen de mémorisation de coefficients d'au moins deux filtres,
des moyens de multiplication d'un desdits coefficient par un échantillon, et
des moyens d'accumulation des sommes partielles de résultats de multiplication pour chacun desdits filtres.

Dans ce dispositif, les filtres sont indépendents les uns des autres et les calculs relatifs à chaque filtres sont effectués séparément.

Un but de l'invention est de fournir un dispositif de filtrage digital d'échantillon qui soit adapté à effectuer des calculs pour des filtres digitaux en série et qui soit plus efficace que les dispositifs de l'art antérieur.

Selon l'invention, le dispositif de filtrage digital d'échantillons est caractérisé par le fait que ledit moyen de mémorisation comporte de manière entrelacée les coefficients desdits filtres ainsi que, pour chaque coefficient, une donnée identifiant le filtre auquel appartient ledit coefficient.

Un tel multiplexage permet l'utilisation d'un seul multiplieur pour effectuer des calculs relatifs à différents filtres digitaux en série. De plus, la façon dont les données sont stockées dans la ROM permet d'ordonner l'ordre des calculs et de fixer le moment d'apparition des échantillons filtrés en sortie du dispositif.

Selon un mode de réalisation particulier, ledit moyen de mémorisation est une mémoire morte.

Selon un mode de réalisation particulier, les moyens de multiplication comprennent un unique multiplicateur.

Selon un mode de réalisation particulier, lesdits moyens d'accumulation comportent des registres tampon.

Selon un mode de réalisation particulier, ledit moyen de mémorisation contient les coefficients d'un premier et d'un second filtres en série.

Selon un mode de réalisation particulier, ledit dispositif comporte deux mémoires vives dont la première stocke lesdits échantillons, tandis que la seconde stocke les échantillons filtrés par le premier desdits filtres.

Selon un mode de réalisation particulier, au moins un des filtres comporte des moyens pour réaliser un suréchantillonnage.

Selon un mode de réalisation particulier, ledit moyen de mémorisation contient de manière répétitive les coefficients de filtres appliqués auxdits échantillons après un filtre réalisant un suréchantillonnage.

Selon un mode de réalisation particulier, seuls les coefficients non nuls d'un filtre symétrique sont stockés.

Selon un mode de réalisation particulier, le dispositif comporte en outre un moyen pour effectuer à part les calculs concernant le coefficient central non nul d'un filtre symétrique.

Selon un mode de réalisation particulier, le dispositif comprend en outre des moyens de lecture séquentielle de chaque coefficient stocké dans ledit moyen de mémorisation, ledit coefficient lu étant transmis auxdits moyens de multiplication (9) pour être multiplié par un desdits échantillons et, dans ce dispositif, lesdites données identifiant le filtre auquel appartient ledit coefficient déterminent par quels moyens d'accumulation le résultat de la multiplication sera accumulé.

Selon un mode de réalisation particulier, tous les résultats accumulés dans les moyens d'accumulation du dispositif sont évacués desdits moyens d'accumulation après la fin des calculs relatifs à un filtre donné

D'autres caractéristiques de l'invention apparaîtront à travers la description d'un exemple de réalisation particulier et non limitatif illustré par les figures jointes parmi lesquelles:
- la figure 1 représente symboliquement le suréchantillonnage effectué par les filtres du présent exemple,
- la figure 2 représente schématiquement un circuit conforme à l'invention, et
- la figure 3 représente un organigramme décrivant le fonctionnement du circuit de la figure 2.

Selon le présent exemple de réalisation, on soumet des échantillons à fréquence Fs successivement à deux filtres, FA et FB. Le premier filtre FA est un filtre demi-bande symétrique du 133e ordre, réalisant un suréchantillonnage de facteur 2. Grâce à ses propriétés inhérentes, ce filtre peut être implémenté à l'aide de 33 coefficients. Le second filtre FB est un filtre du 46e ordre, représenté à l'aide de 46 coefficients et réalisant un suréchantillonnage supplémentaire de facteur 4. Globalement, les deux filtres en série suréchantillonnent donc d'un facteur 8. Les principes du suréchantillonnage utilisés par les filtres sont en soi bien connus et ne seront pas détaillés davantage.

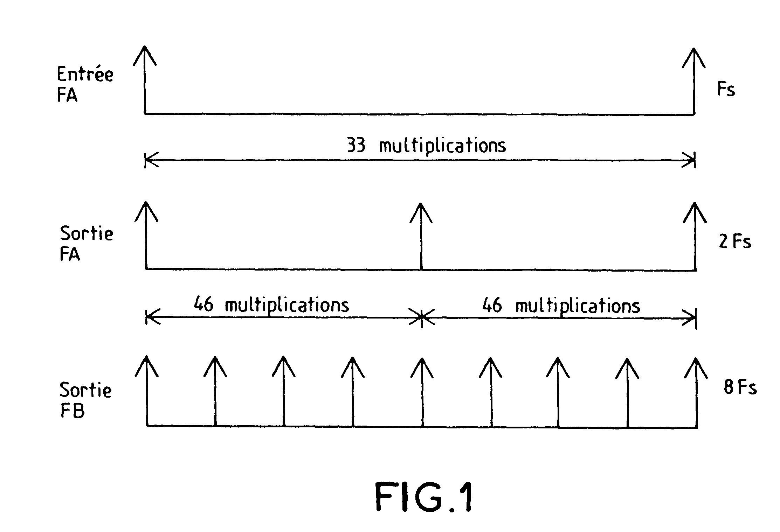

La figure 1 illustre le suréchantillonnage en faisant figurer deux échantillons du signal d'entrée et les échantillons à la sortie des deux filtres FA et FB. Pendant une période de Fs, 33 multiplications doivent être réalisées pour la mise en oeuvre du filtre FA, et 2*46=92 pour la mise en oeuvre du filtre FB, ce qui fait un total de 125 multiplications. On peut donc faire fonctionner le circuit avec une horloge dont la fréquence est égale au minimum à 125*Fs. Pour des raisons évidentes de simplification, on choisit une horloge de 128*Fs.

Il est à noter que si le circuit conforme au présent exemple est implémenté dans un circuit de traitement audio, on doublera la fréquence d'horloge suivant la nature mono ou stéréo des signaux à traiter.

Le rapport entre le nombre de multiplications à effectuer pour FA et celui pour FB est d'environ 1/3. On effectue une multiplication pour FA, puis trois pour FB et ainsi de suite jusqu'à épuisement des 46 coefficients du filtre FB. La seconde série de 46 coefficients est traitée de manière similaire. Le tableau 1 donne l'arrangement des coefficients dans la ROM.

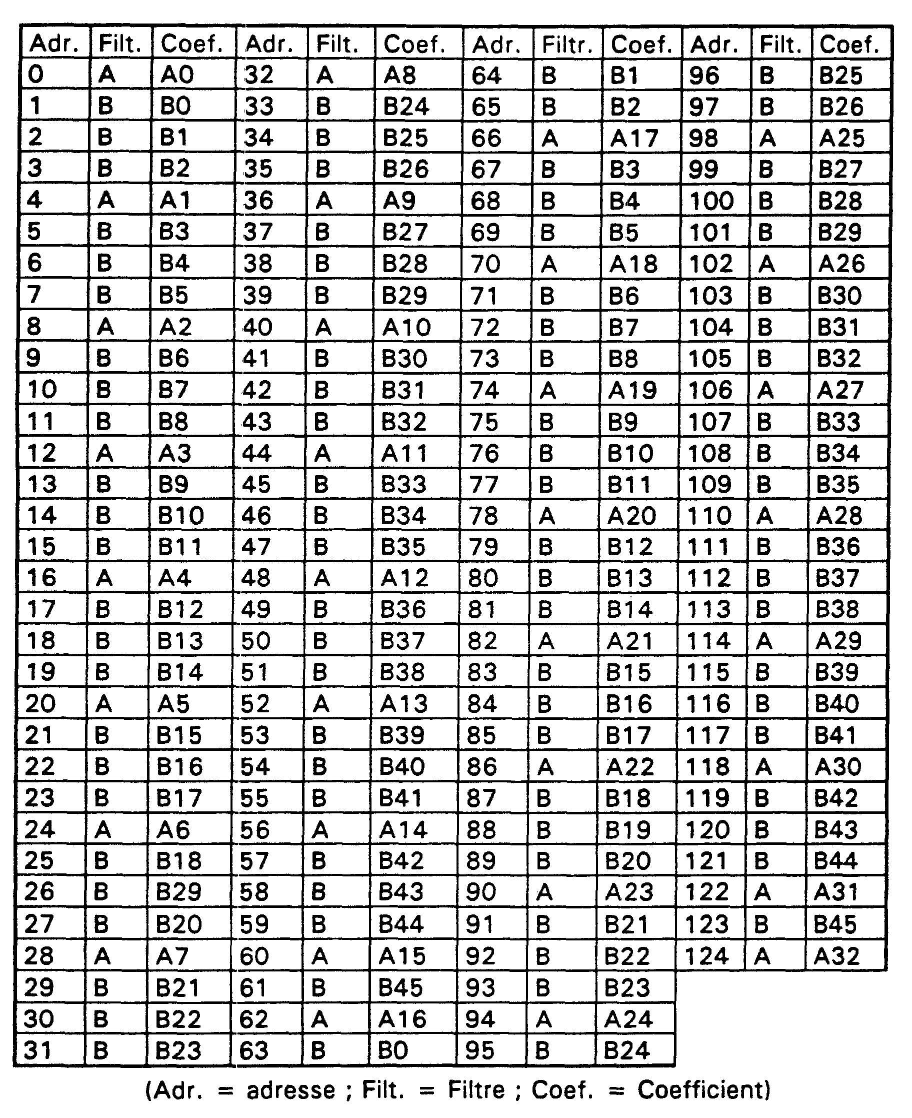

Ai désigne les coefficients du premier filtre, tandis que Bi désigne les coefficients du second filtre.

On remarquera que le tableau contient de manière répétitive les coefficients du filtre FB, ces coefficients étant utilisés à la fréquence 2*Fs étant donné que le filtre FA suréchantillonne d'un facteur 2.

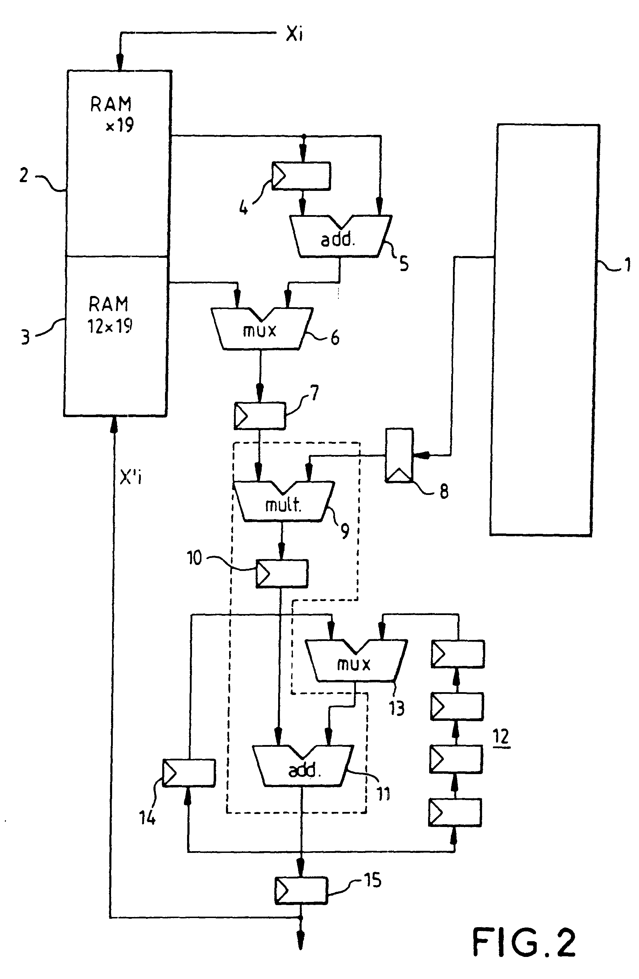

La figure 2 est un schéma fonctionnel du circuit conforme au présent exemple de réalisation. La mémoire morte 1 contient en substance les informations du tableau 1, chaque coefficient étant codé sur 17 bits. Un bit supplémentaire est alloué pour chaque coefficient pour indiquer le filtre auquel il appartient. La mémoire morte 1, qui a donc une taille de 125*18 bits, est lue séquentiellement. C'est le bit d'identification du filtre qui détermine les différents multiplexages réalisés dans le reste du circuit. En cela, le contenu de la mémoire morte forme un programme de séquencement des opérations à l'intérieur du circuit.

Le circuit de la figure 2 comporte également une mémoire vive 2 qui stocke les échantillons en entrée de FA (échantillons Xi) et une mémoire vive 3 stockant les échantillons en entrée de FB (échantillons X'i). Les échantillons sont codés sur 19 bits. La mémoire vive 2 stocke 67 échantillons pour le filtre FA, tandis que la mémoire vive 3 stocke 12 pour le filtre FB, étant donné les suréchantillonnages effectués.

Etant donné le caractère symétrique du filtre FA, un premier échantillon lu dans la mémoire 2 est mémorisé dans un registre tampon 4, un second échantillon étant lu pour être additionné au premier par l'intermédiaire d'un additionneur 5. Cette somme de coefficients est alors multiplexée par un multiplexeur 6 avec un des échantillons lus dans la mémoire vive 3. Le multiplexeur 6 est commandé par l'état du bit d'identification du filtre lu dans la ROM 1. La sortie du multiplexeur 6 est mémorisée dans un registre tampon 7, tandis que le coefficient lu dans la ROM 1 est mémorisé dans un registre 8.

Le contenu des registres 7 et 8 est multiplié par un multiplieur 9, le résultat étant stocké dans le registre tampon 10 pour être additionné par un additionneur 11 à la somme partielle déjà réalisée pour le filtre auquel il correspond.

La somme partielle correspondant au filtre FA est stockée dans un registre tampon 14. Pour des raisons vues plus loin (les coefficients nuls et le coefficient central du filtre n'étant pas stockés dans la ROM 1), le circuit de la figure 2 ne calcule qu'un résultat sur deux du filtre FA. C'est pour cela qu'un seul registre tampon est utilisé ici.

Le filtre FB fournit quatre résultats par demi-période de Fs, c'est à dire pour 46 multiplications. Ces quatre résultats sont stockés dans un registre à décalage 12 formé de quatre registres tampon en série. Ces quatre résultats correspondent aux sommes partielles s'accumulant lors des calculs effectués pour les quatre derniers coefficients (42 à 45) du filtre FB Ces résultats sont évacués en série après le calcul effectué pour le dernier coefficient.

Le registre à décalage 12 reboucle lui aussi sur le multiplexeur 13. Comme le multiplexeur 6, le multiplexeur 13 est commandé, lors des phases de multiplication, par l'état du bit d'identification du filtre. Les deux registres 12 et 14 reçoivent la sortie de l'additionneur 11. Tout résultat final de l'un des filtres est stocké dans un registre 15. Lorsque ce résultat appartient au filtre FA, il est stocké dans la RAM 3 pour être ultérieurement utilisé par le filtre FB. Les résultats en sortie du filtre FB sont disponibles en sortie du registre 15.

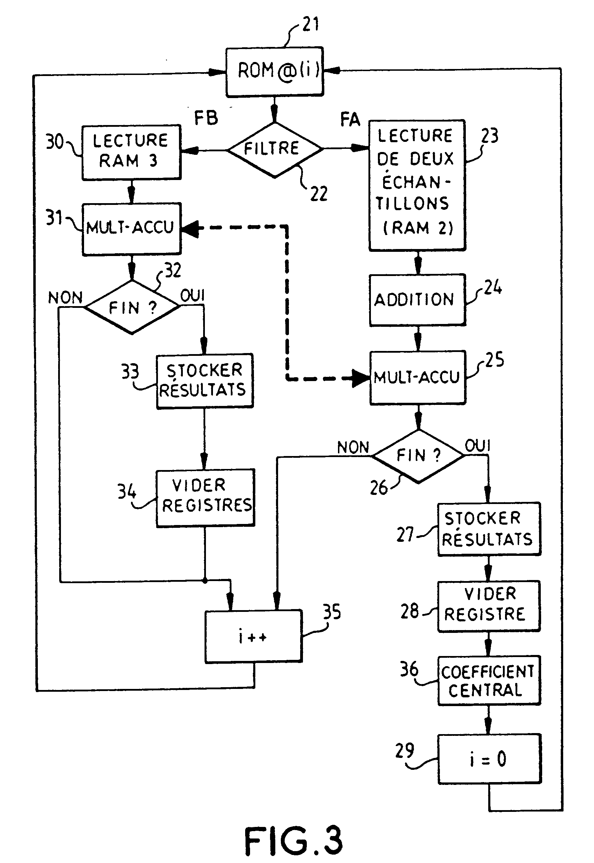

La figure 3 est un organigramme illustrant le fonctionnement du circuit de la figure 2. Pour la clarté des explications, le traitement des deux filtres a été artificiellement séparé. L'indice i correspond à l'indice d'ordre des coefficients dans la mémoire morte 1, @(i) indiquant l'adresse du coefficient i.

Selon le présent exemple, le contrôle du circuit est exercé par un microprocesseur non illustré.

La première étape 21 consiste à lire la mémoire morte 1 à l'adresse @(i), l'indice i ayant été au préalable initialisé à la valeur appropriée. Le bit d'identification du filtre du coefficient i est testé lors d'une étape 22 (coefficients Ai pour le filtre FA et Bi pour le filtre FB). Les étapes 23 à 29 correspondent au premier filtre, tandis que les étapes 30 à 33 correspondent au second filtre.

L'étape 23 correspond à la lecture de deux échantillons dans la mémoire vive 2. Il s'agit des deux échantillons "symétriques" correspondant au coefficient Ai, le filtre FA étant un filtre symétrique. Ces deux coefficients sont ensuite additionnés lors d'une étape 24, multipliés par Ai, le résultat étant ajouté à la somme partielle en cours. On teste alors si le dernier coefficient de FA a été traité (étape 26).

Dans l'affirmative, le résultat d'accumulation final est stocké dans la RAM 3, le registre à décalage 14 est réinitialisé à zéro, l'indice i est également mis à zéro (respectivement étapes 27 à 29) et la lecture de la ROM 1 est reprise depuis le début. Dans la négative, on incrémente i (étape 35) et on reprend la lecture de la ROM 1.

L'étape 30 correspond à la lecture d'un échantillon de la RAM 3 pour le calcul correspondant au filtre FB. L'échantillon est multiplié par Bi et accumulé avec la somme partielle correspondante déjà calculée. On teste alors (étape 32) si Bi correspond à un dernier coefficient (45) de FB. Si c'est le cas, les quatre résultats des accumulations successives sont transmis à la sortie du circuit et le registre d'accumulation 12 est réinitialisé. Si ce n'est pas le cas, i est incrémenté et on reprend la lecture de la ROM 1.

La double flèche hachurée du schéma de la figure 3 indique que les étapes 25 et 31 sont effectuées par le même élément de circuit.

Le filtre FA est dans le présent cas un filtre dont le coefficient central est non nul. Il s'agit là du seul coefficient d'ordre impair non nul. Une conséquence du suréchantillonnage d'un facteur deux en entrée du filtre FA est que chaque second résultat en sortie du filtre résulte uniquement de la multiplication de ce coefficient central par un échantillon, toutes les autres multiplications ayant un résultat nul. En effet, si la séquence des échantillons est:
*x*₀,*x*₁,*x*₂,..., alors le filtre FA traite:
*x*₀,0,*x*₁,0,*x*₂,0...

Or, les coefficients du filtre sont du type:
*C*₀,0,*C*₂,0...0,*C*_{*central*}₋₁,*C*_{*central*}*,C*_{*central*}₊₁,0...0,*C*_{*n*}.

Dans un premier temps, le résultat suivant est calculé:
*C*₀*x*₀+*C*₂*x*₁+...

Lors de la seconde alternance, le calcul suivant devrait être effectué:
*C*₀*0+0**x*₁+*C*₂*0+...+C_{*central*}**x*_{*i*}+...+0**x*_{*n*}

Seul
*C*_{*central*}**x*_{*i*} n'est pas nul.

En conséquence, seule une alternance sur deux est calculée en utilisant l'entrelacement indiqué. Le cas du coefficient central est traité à part lors d'une étape 36, pour éviter un grand nombre de calculs inutiles par le multiplieur 9. C'est le microprocesseur (ou équivalent) qui effectue directement le calcul et stocke le résultat dans la RAM 3.

Bien entendu, l'invention ne se limite pas à l'exemple de réalisation décrit ci-dessus. Elle s'applique aussi à un nombre de filtres plus importants et dans des cas où il n'y a pas de suréchantillonnage. De même, les filtres ne sont pas nécessairement en série, mais peuvent être disposés en parallèle.

Selon un mode de réalisation particulier, on prévoit une seule RAM pour les deux filtres, ceci permettant de simplifier l'adressage.

## Revendications

1. Dispositif de filtrage digital d'échantillons comprenant:
un moyen de mémorisation (1) de coefficients (Ai, Bi) d'au moins deux filtres (FA, FB),
des moyens de multiplication (9) d'un desdits coefficients (Ai, Bi) par un échantillon (Xi, X'i),
des moyens d'accumulation (12, 14) des sommes partielles de résultats de multiplication pour chacun desdits filtres (FA, FB),
caractérisé en ce que ledit moyen de mémorisation comporte de manière entrelacée les coefficients desdits filtres ainsi que, pour chaque coefficient, une donnée identifiant le filtre auquel appartient ledit coefficient.

2. Dispositif selon la revendication 1, caractérisé en ce que ledit moyen de mémorisation est une mémoire morte (1).

3. Dispositif selon la revendication 1 ou 2, caractérisé en ce que les moyens de multiplication (9) comprennent un unique multiplicateur.

4. Dispositif selon l'une des revendications précédentes, caractérisé en ce que lesdits moyens d'accumulation (12, 14) comportent des registres tampon.

5. Dispositif selon l'une des revendications précédentes, caractérisé en ce qu'au moins un des deux filtres comporte des moyens pour réaliser un suréchantillonnage.

6. Dispositif selon la revendication 5, caractérisé en ce que ledit moyen de mémorisation (1) contient de manière répétitive les coefficients de filtres (FB) appliqués auxdits échantillons après un filtre (FA) réalisant un suréchantillonnage.

7. Dispositif selon l'une des revendications précédentes, caractérisé en ce que seuls les coefficients non nuls d'un filtre symétrique (FA) sont stockés.

8. Dispositif selon la revendication 7, caractérisé en ce qu'il comporte en outre un moyen pour effectuer à part les calculs concernant le coefficient central non nul d'un filtre symétrique (FA).

9. Dispositif selon l'une des revendications précédentes, caractérisé en ce que ledit moyen de mémorisation contient les coefficients d'un premier et d'un second filtres en série (FA, FB).

10. Dispositif selon la revendication 9, caractérisé en ce qu'il comporte deux mémoires vives (2, 3) dont la première (2) stocke lesdits échantillons (Xi), tandis que la seconde (3) stocke les échantillons filtrés par le premier desdits filtres (FA).

11. Dispositif selon l'une des revendications précédentes, caractérisé en ce qu'il comprend en outre des moyens de lecture séquentielle de chaque coefficient stocké dans ledit moyen de mémorisation;
ledit coefficient lu étant transmis auxdits moyens de multiplication (9) pour être multiplié par un desdits échantillons,
dans lequel lesdites données identifiant le filtre auquel appartient ledit coefficient déterminent par quels moyens d'accumulation (12, 14) le résultat de la multiplication sera accumulé.

12. Dispositif selon l'une des revendications précédentes, dans lequel tous les résultats accumulés dans lesdits moyens d'accumulation (12, 14) sont évacués desdits moyens d'accumulation après la fin des calculs relatifs à un filtre donné.

## Claims

1. Device for the digital filtering of samples comprising:
a storage means (1) for storing coefficients (Ai, Bi) of at least two filters (FA, FB),
multiplication means (9) for multiplying one of the said coefficients (Ai, Bi) by a sample (Xi, X'i),
accumulation means (12, 14) for accumulating the partial sums of multiplication results for each of the said filters (FA, FB),
characterized in that the said storage means includes in an interlaced manner the coefficients of the said filters together with, for each coefficient, a data item identifying the filter to which the said coefficient belongs.

2. Device according to Claim 1, characterized in that the said storage means is a read only memory (1).

3. Device according to Claim 1 or 2, characterized in that the multiplication means (1) comprise a single multiplier.

4. Device according to one of the preceding claims, characterized in that the said accumulation means (12, 14) include buffer registers.

5. Device according to one of the preceding claims, characterized in that at least one of the two filters includes means for carrying out an oversampling.

6. Device according to Claim 5, characterized in that the said storage means (1) contains in a repetitive manner the coefficients of filters (FB) applied to the said samples after a filter (FA) carrying out an oversampling.

7. Device according to one of the preceding claims, characterized in that only the non-zero coefficients of a symmetric filter (FA) are stored.

8. Device according to Claim 7, characterized in that it furthermore includes a means for separately performing the calculations relating to the non-zero central coefficient of a symmetric filter (FA).

9. Device according to one of the preceding claims, characterized in that the said storage means contains the coefficients of a first and of a second filter in series (FA, FB).

10. Device according to Claim 9, characterized in that it includes two random access memories (2, 3), the first (2) of which stores the said samples (Xi), whilst the second (3) stores the samples filtered by the first of the said filters (FA).

11. Device according to one of the preceding claims, characterized in that it furthermore comprises means of sequential reading of each coefficient stored in the said storage means;
the said read coefficient being transmitted to the said multiplication means (9) so as to be multiplied by one of the said samples,
in which the said data identifying the filter to which the said coefficient belongs determine by which accumulation means (12, 14) the result of the multiplication will be accumulated.

12. Device according to one of the preceding claims, in which all the results accumulated in the said accumulation means (12, 14) are released from the said accumulation means after the end of the calculations relating to a given filter.

## Patentansprüche

1. Vorrichtung zur Filterung von digitalen Abtastwerten mit:
Speichermitteln (1) für Koeffizienten (Ai, Bi) von wenigstens zwei Filtern (FA, FB),
Mitteln zur Multiplikation (9) eines der Koeffizienten (Ai, Bi) mit einem Abtastwert (Xi, X'i),
Mitteln zur Akkumulation (12, 14) der partiellen Summen der Ergebnisse der Multiplikation für jedes der Filter (FA, FB),
dadurch gekennzeichnet, daß die Mittel zur Speicherung in verschachtelter Weise die Koeffizienten der Filter sowie für jeden Koeffizienten ein Datenwort enthalten, das dasjenige Filter identifiziert, zu dem der genannten Koeffizient gehört.

2. Vorrichtung nach Anspruch 1, dadurch gekennzeichnet, daß die Mittel zur Speicherung durch einen ROM-Speicher (1) gebildet sind.

3. Vorrichtung nach Anspruch 1 oder 2, dadurch gekennzeichnet, daß die Mittel zur Multiplikation (9) einen einzigen Multiplikator enthalten.

4. Vorrichtung nach einem der vorangehenden Ansprüche, dadurch gekennzeichnet, daß die Mittel (12, 14) zur Akkumulation Zwischenspeicher enthalten.

5. Vorrichtung nach einem der vorangehenden Ansprüche, dadurch gekennzeichnet, daß wenigstens eines der beiden Filter Mittel zur Durchführung einer Überabtastung enthält.

6. Vorrichtung nach Anspruch 5, dadurch gekennzeichnet, daß die Mittel zur Speicherung (1) in sich wiederholender Art die Filterkoeffizienten (FB) enthalten, die nach einem eine Überabtastung bewirkenden Filter (FA) auf die Abtastwerte angewendet werden.

7. Vorrichtung nach einem der vorangehenden Ansprüche, dadurch gekennzeichnet, daß nur die von null abweichenden Koeffizienten eines symmetrischen Filters (FA) gespeichert werden.

8. Vorrichtung nach Anspruch 7, dadurch gekennzeichnet, daß sie unter anderem Mittel zur gesonderten Durchführung der Berechnungen für den von null abweichenden mittleren Koeffizienten eines symmetrischen Filters (FA) enthalten.

9. Vorrichtung nach einem der vorangehenden Ansprüche, dadurch gekennzeichnet, daß die Mittel zur Speicherung die Koeffizienten eines in Reihe angeordneten ersten und zweiten Filters (FA, FB) enthalten.

10. Vorrichtung nach Anspruch 9, dadurch gekennzeichnet, daß sie zwei RAM-Speicher (2,3) enthält, von denen der erste (2) die Abtastwerte (Xi) speichert, während der zweite (3) die durch das erste (FA) Filter gefilterten Abtastwerte speichert.

11. Vorrichtung nach einem der vorangehenden Ansprüche, dadurch gekennzeichnet, daß sie unter anderem Mittel zum sequentiellen Lesen jedes in den Mitteln zur Speicherung gespeicherten Koeffizienten enthält,
daß der gelesene Koeffizient zu den Mitteln (9) zur Multiplikation übertragen wird, um mit einem der Abtastwerte multipliziert zu werden,
wobei die Daten, die das Filter identifizieren, zu dem der Koeffizient gehört, bestimmen, durch welche Mittel (12, 14) zur Akkumulation das Multiplikationsergebnis akkumuliert werden.

12. Vorrichtung nach einem der vorangehenden Ansprüche, wobei alle in den Mitteln (12, 14) zur Akkumulation akkumulierten Ergebnisse am Ende der Berechnungen für ein gegebenes Filter von den Mittel zur Akkumulation gelöscht werden.
